# EUROPÄISCHE PATENTSCHRIFT

(11) **EP 1 216 488 B1**
(45) Veröffentlichungstag und Bekanntmachung des Hinweises auf die Patenterteilung: **10.12.2003**
(21) Anmeldenummer: 00971258.9
(22) Anmeldetag: 26.09.2000
(51) Int. Cl.: H01L 29/74

(54) **THYRISTOR MIT SPANNUNGSSTOSSBELASTBARKEIT IN DER FREIWERDEZEIT**
THYRISTOR WITH RECOVERY TIME VOLTAGE SURGE RESISTANCE
THYRISTOR A CHARGE ADMISSIBLE D'ONDE DE TENSION DANS LE TEMPS DE RECOUVREMENT

(30) Priorität: 30.09.1999 DE 19947028
(43) Veröffentlichungstag der Anmeldung: 26.06.2002
(73) Patentinhaber: SIEMENS AKTIENGESELLSCHAFT, 80333 München (DE)
(72) Erfinder: NIEDERNOSTHEIDE, Franz, Josef, D-81739 München (DE); SCHULZE, Hans-Joachim, D-85521 Ottobrunn (DE)
(86) Internationale Anmeldenummer: DE0003351
(87) Internationale Veröffentlichungsnummer: WO01024274

(56) Entgegenhaltungen:
- EP-A- 0 714 139
- WO-A-98/15010
- WO-A-98/34282
- MITLEHNER H ET AL: "HIGH VOLTAGE THYRISTOR FOR HVDC TRANSMISSION AND STATIC VAR COMPENSATORS" PROCEEDINGS OF THE ANNUAL POWER ELECTRONICS SPECIALISTS CONFERENCE. (PESC),US,NEW YORK, IEEE, Bd. CONF. 19, 11. April 1988 (1988-04-11), Seiten 934-939, XP000044744 ISSN: 0275-9306 in der Anmeldung erwähnt

## Beschreibung

Die Erfindung betrifft einen Thyristor mit dem folgenden Aufbau:

In einem Körper aus unterschiedlich dotiertem Halbleitermaterial, der eine als Kathode dienende Elektrode und eine als Anode dienende Elektrode aufweist, sind
- ein kathodenseitiger Emitter eines ersten Leitungstyps
- eine kathodenseitige Basis eines zweiten Leitungstyps,
- eine anodenseitige Basis des ersten Leitungstyps,
- ein anodenseitiger Emitter des zweiten Leitungstyps und
- wenigstens eine Treiberstufe zum Verstärken eines in die kathodenseitige Basis eingespeisten Steuerstromes ausgebildet, und
- die Treiberstufe weist einen in der kathodenseitigen Basis ausgebildeten und vom kathodenseitigen Emitter getrennten weiteren Emitter des ersten Leitungstyps sowie eine sowohl die kathodenseitige Basis als auch den weiteren Emitter kontaktierende Metallisierung auf.

Ein Thyristor der genannten Art ist aus H. Mitlehner, J. Sack, H.-J- Schulze: " High Voltage Thyristor for HVDC Transmission and Static VAR Compensators", Proceedings of PESC, Kyoto, 1988, S. 934 oder aus WO 98/34282 (97P1089) bekannt. Bei diesem bekannten Thyristor ist der kathodenseitige Emitter des ersten Leitungstyps durch einen an eine Hauptfläche des scheibenförmigen, aus Halbleitermaterial in Form von Silizium bestehenden Körpers grenzenden n⁺-dotierten Bereich dieses Körpers definiert.

Die kathodenseitige Basis des zweiten Leitungstyps ist durch einen an den n⁺-dotierten Bereich grenzenden und zusammen mit diesem Bereich einen np-Übergang bildenden p-dotierten Bereich des Körpers definiert.

Die anodenseitige Basis des ersten Leitungstyps ist durch einen n⁻-dotierten Bereich und einen n⁺-dotierten Bereich des Körpers definiert, die aneinandergrenzen und von denen der n⁻ -dotierten Bereich an den p-dotierten Bereich der kathodenseitigen Basis grenzt und zusammen mit diesem Bereich einen pn-Übergang bildet.

Der anodenseitige Emitter es zweiten Leitungstyps ist durch einen p⁺-dotierten Bereich des Körpers definiert, der einerseits an den n⁺-dotierten Bereich der anodenseitigen Basis grenzt und zusammen mit diesem Bereich einen np-Übergang bildet und andererseits an die von der einen Hauptfläche abgekehrte Hauptfläche des Körpers grenzt.

Im kathodenseitigen Emitter des Thyristors sind Kathodenkurzschlüsse ausgebildet, welche die kathodenseitige Basis und die Kathode miteinander verbinden und die gewährleisten, daß der Thyristor auch bei einer großen dU/dt-Belastung von einigen 1000 Volt/µs nicht bereits vor dem Erreichen der statischen Kippspannung unkontrolliert zündet.

Um den Einfluß eines Leckstromes auf einen unterhalb der Kathode des Thyristors durch die kathodenseitige Basis, die anodenseitigen Basis und den anodenseitigen Emitter definierten Transistorverstärkungsfaktor αₚₙₚ des Thyristors bei geringer Leckstromdichte zu unterdrücken, sind im anodenseitigen Emitter mehrere Anodenkurzschlüsse ausgebildet, welche die anodenseitige Basis und die Anode miteinander verbinden.

Der weitere Emitter der einzigen Treiberstufe ("Amplifying-Gate") ist durch einen an die eine Hauptfläche des Körpers grenzenden, aber vom n⁺-dotierten Bereich des kathodenseitigen Emitters räumlich getrennten n⁺-dotierten Bereich definiert, der im p-dotierten Bereich der kathodenseitigen Basis ausgebildet ist und zusammen mit diesem Bereich einen np-Übergang bildet.

Der p-dotierte Bereich der kathodenseitigen Basis grenzt seitlich neben dem n⁺-dotierten Bereich des weiteren Emitters ebenfalls an die eine Hauptfläche des Körpers. Die Metallisierung ist auf dieser einen Hauptfläche aufgebracht und kontaktiert sowohl den p-dotierten Bereich der kathodenseitigen Basis als auch den n⁺-dotierten Bereich des weiteren Emitters.

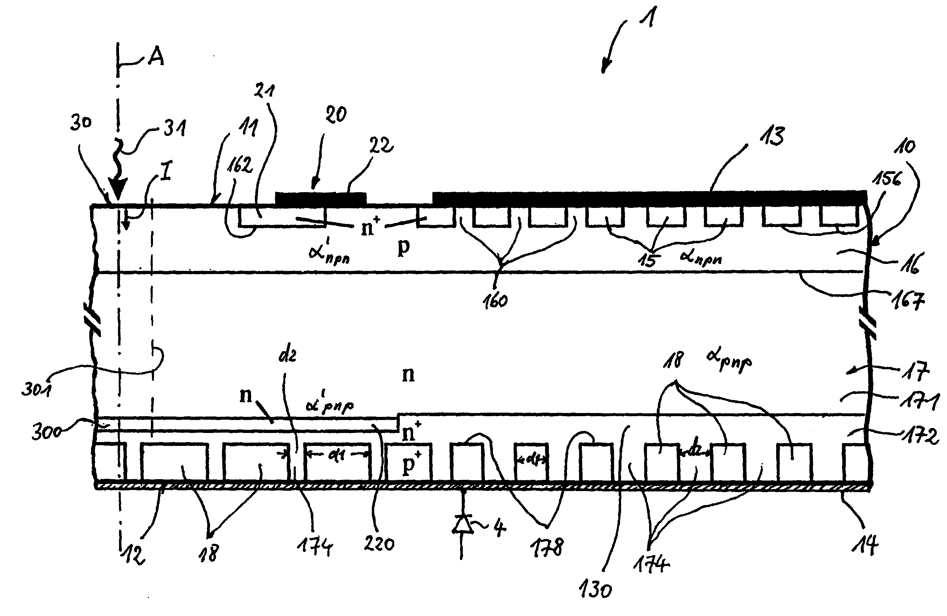

Anstelle nur einer solchen Treiberstufe können deren zwei oder mehrere vorhanden sein (siehe beispielsweise Figur 5 des oben zuerst genannten Dokuments).

Der in den p-dotierten Bereich der kathodenseitigen Basis eingespeiste Steuerstrom wird an einer Stelle neben dem n⁺dotierten weiteren Emitter der Treiberstufe erzeugt, bei welcher der p-dotierte Bereich der kathodenseitigen Basis frei von der Metallisierung der Treiberstufe an die eine Hauptfläche des- Körpers grenzt.

Der Steuerstrom kann mit Hilfe eines Zündkontaktes und/oder einer lichtempfindlichen Struktur erzeugt werden, der bzw. die an dieser Stelle an der einen Hauptfläche des Körpers ausgebildet sind/ist.

Insbesondere ist der Thyristor bezüglich einer auf den beiden Hauptflächen des Körpers senkrecht stehenden Achse rotationssymmetrisch ausgebildet. Die Stelle zum Einspeisen des Steuerstroms liegt in einem die Achse umgebenden zentralen Teilbereich der einen Hauptfläche des scheibenförmigen Körpers.

Die Treiberstufe ist radial zur Achse zwischen dem zentralen Teilbereich und der Kathode des Thyristors angeordnet.

Der bekannte Thyrsistor ist überdies ein asymmetrischer Thyristor, der eine Stoppzone des ersten Leitungstyps aufweist, die durch den n⁺-dotierten Bereich der anodenseitigen Basis gebildet ist. Diese Stoppzone bewirkt, daß die Überkopfzündung des Thyristors nicht durch einen Lawinendurchbruch (Avalanche-Effekt), sondern durch den sogenannten "Punchthrough"-Effekt, d.h. durch die Ausdehnung der Raumladungszone des in Sperrrichtung gepolten pn-Übergangs zwischen der kathodenseitigen Basis und der anodenseitigen Basis bis hin zu dem in Durchlaßrichtung gepolten np-Übergang zwischen der anodenseitigen Basis und dem anodenseitigen Emitter im Körper aus Halbleitermaterial erzwungen wird.

Der aus dem oben zuerst genannten Dokument bekannte asymmetrische Thyristor weist die Besonderheit auf, daß er mit einer Diode in Reihe geschaltet ist und zusammen mit dieser Diode einen Tandemthyristor bildet, der eine Alternative zu einem aus zwei in Reihe geschalteten symmetrischen Thyristoren bestehenden Tandemthyristor ist.

Der aus WO 98/34282 bekannte Thyristor weist die Besonderheit auf, daß die n⁺-dotierte Stoppzone in einem unterhalb des zentralen Teilbereichs liegenden Bereich schwächer dotiert ist als im lateral angrenzenden Bereich. Diese Besonderheit hat den Vorteil, daß die Kippspannung des Thyristors nicht oder nur unwesentlich von der Temperatur abhängt. Dabei besteht überdies der Vorteil, daß sich eine Stoppzone, die neben einem höher dotierten Bereich einen vergleichsweise schwächer dotierten Bereich aufweist, einfach und kostengünstig, beispielsweise mittels "maskierter" Implantation, herstellen läßt.

Aus H.-J. Schulze, M. Ruff, B. Baur, F. Pfirsch, H. Kabza, U. Kellner, P. Voss: " Light Triggered 8 kV Thyristor with a New Type of Integrated Breakover Diode", Proceedings of PCIM, Maui, 1996, S. 465 - 472 ist es bekannt, bei symmetrisch sperrenden Thyristoren in einer im Zentralbereich des Thyristors befindlichen Amplifying-Gate-Struktur eine höhere Trägerlebensdauer als im Bereich unter der Kathode der einen Hauptfläche des Körpers aus Halbleitermaterial zu realisieren.

Ein Thyristor mit einer Treibestufe (entsprechend der Preambel des Anspruchs 1) ist auch aus WO 98/150 10 bekannt.

Der Erfindung liegt die Aufgabe zu Grunde, einen Thyristor bereitzustellen, der innerhalb der Freiwerdezeit mit einem Spannungsstoß belastet werden kann, ohne daß dabei der Thyristor durch eine in dem unterhalb der Kathode des Thyristors liegenden Bereich des Körpers aus Halbleitermaterial üblicherweise auftretende Stromfilamentierung zerstört wird.

Diese Aufgabe wird durch die im kennzeichnenden Teil des Anspruches 1 angegebenen Merkmale gelöst.

Gemäß dieser Lösung ist ein Thyristor mit dem folgenden Aufbau bereitgestellt:

In einem Körper aus unterschiedlich dotiertem Halbleitermaterial, der eine als Kathode dienende Elektrode sowie eine als Anode dienende Elektrode aufweist, sind
- ein kathodenseitiger Emitter eines ersten Leitungstyps
- eine kathodenseitige Basis eines zweiten Leitungstyps,
- eine anodenseitige Basis des ersten Leitungstyps,
- ein anodenseitiger Emitter des zweiten Leitungstyps und
- wenigstens eine Treiberstufe zum Verstärken eines in die kathodenseitige Basis eingespeisten Steuerstromes ausgebildet,
- die Treiberstufe weist einen in der kathodenseitigen Basis ausgebildeten und vom kathodenseitigen Emitter getrennten weiteren Emitter des ersten Leitungstyps sowie eine sowohl die kathodenseitige Basis als auch den weiteren Emitter kontaktierende Metallisierung auf,
- ein unterhalb der Metallisierung der wenigstens einen Treiberstufe durch den weiteren Emitter, die kathodenseitige Basis und die anodenseitige Basis definierter Transistorverstärkungsfaktor α'ₙₚₙ dieser Treiberstufe ist größer als ein unterhalb der Kathode des Thyristors durch den kathodenseitigen Emitter, die kathodenseitige Basis und die anodenseitige Basis definierter Transistorverstärkungsfaktor αₙₚₙ des Thyristors,
und/oder
- ein unterhalb der Metallisierung der wenigstens einen Treiberstufe durch die kathodenseitige Basis, die anodenseitige Basis und den anodenseitigen Emitter definierter Transistorverstärkungsfaktor α'ₚₙₚ dieser Treiberstufe ist größer als ein unterhalb der Kathode des Thyristors durch die kathodenseitige Basis, die anodenseitige Basis und den anodenseitigen Emitter definierter Transistorverstärkungsfaktor αₚₙₚ des Thyristors, und/oder
- Anodenkurzschlüsse verbinden die anodenseitige Basis und die Anode miteinander und weisen unterhalb der Metallisierung der wenigstens einen Treiberstufe eine kleinere elektrische Leitfähigkeit als unterhalb der Kathode des Thyristors auf.

Danach unterscheidet sich der erfindungsgemäße Thyristor von dem Thyristor der eingangs genannten Art dadurch, daß der Transistorverstärkungsfaktor α'ₙₚₙ der wenigstens einen Treiberstufe größer ist als der Transistorverstärkungsfaktor αₙₚₙ des Thyristors und/oder daß der Transistorverstärkungsfaktor α'ₚₙₚ dieser Treiberstufe größer ist als der Transistorverstärkungsfaktor αₚₙₚ des Thyristors.

Durch diese Lösung wird vorteilhafterweise erreicht, daß eine durch einen Spannungsstoß innerhalb der Freiwerdezeit ausgelöste Zündung des Thyristors zuerst außerhalb des unterhalb der Kathode des Thyristors liegenden Bereichs des Körpers aus Halbleitermaterial und möglichst innerhalb einer Treiberstufe stattfindet. Die gezielte Verlagerung der Zündung von dem unterhalb der Kathode liegenden Bereich in die Treiberstufe hat zur Folge, daß sich die dem Spannungsstoß folgende Zündfront sehr schnell ausbreiten kann und somit eine Stromfilamentierung vermieden wird.

Die Erfindung beruht auf der Erkenntnis, daß durch Dimensionierung des Thyristors so, daß der Transistorverstärkungsfaktor α'ₙₚₙ und/oder α'ₚₙₚ der zumindest einen Treiberstufe größer, vorzugsweise deutlich höher ist als der Transistorverstärkungsfaktor αₙₚₙ und/oder αₚₙₚ des Thyristors, eine stärkere Überschwemmung mit freien Ladungsträgern und ein Erlöschen des Stromflusses in dieser Treiberstufe behindert wird. Vorzugsweise ist sowohl α'ₙₚₙ größer als αₙₚₙ als auch α'ₚₙₚ größer als αₚₙₚ eingestellt.

Im Regelfall, d.h. ohne eine solche Dimensionierung der Transistorverstärkungsfaktoren α'ₙₚₙ, α'ₚₙₚ, αₙₚₙ und αₚₙₚ tritt die Zündung bei Spannungsstoß innerhalb der Freiwerdezeit nicht in der Treiberstufe, insbesondere in dem unterhalb der Metallisierung dieser Stufe liegenden Bereich auf, weil zu diesem Zeitpunkt in der Treiberstufe - im Gegensatz zu dem unterhalb der Kathode liegenden Bereich des Thyristors - keine oder wenige freie Ladungsträger, die bekanntermaßen den Zündvorgang begünstigen, vorhanden sind. Der Grund hierfür ist, daß die Treiberstufe wesentlich früher als der Thyristors unter der Kathode wieder abschaltet.

Bevorzugter- und vorteilhafterweise weist bei dem erfindungsgemäßen Thyristor die anodenseitige Basis eine Stoppzone des ersten Leitungstyps auf, was bedeutet, daß der Thyristor ein asymmetrischer Thyristor ist.

Bei einem solchen asymmetrischen Thyristor kann vorteilhafterweise eine Erhöhung der Transistorverstärkungsfaktoren α'ₙₚₙ, α'ₚₙₚ der wenigstens einen Treiberstufe gegenüber den Transistorverstärkungsfaktoren αₙₚₙ, αₚₙₚ des Thyristors in dem unterhalb dessen Kathode liegenden Bereich auf einfache Weise dadurch realisiert werden, daß die Stoppzone in dem unterhalb der Metallisierung dieser Treiberstufe liegenden Bereich schwächer dotiert ist als in einem unterhalb der Kathode des Thyristors liegenden Bereich.

Bei einer bevorzugten und vorteilhaften Ausgestaltung dieses asymmetrischen Thyristors ist die Stoppzone in dem unterhalb der Metallisierung der wenigstens einen Treiberstufe liegenden Bereich höher dotiert ist als unterhalb einer Stelle zum Einspeisen eines Steuerstroms in die kathodenseitige Basis. Ein Vorteil dieser Ausgestaltung ist darin zu sehen, daß neben der Spannungsstoßbelastbarkeit in der Freiwerdezeit auch ein Licht- und/oder Überkopfzündschutz des Thyristors gegeben ist.

Die Erfindung beruht auch auf der Erkenntnis, daß alternativ oder zusätzlich zur vorstehenden Dimensionierungsvorschrift das Erlöschen des Stroms in einer Treiberstufe dadurch behindert werden kann, daß Anodenkurzschlüsse die anodenseitige Basis und die Anode miteinander verbinden und unterhalb der Metallisierung der wenigstens einen Treiberstufe eine kleinere elektrische Leitfähigkeit als unterhalb der Kathode des Thyristors aufweisen.

Die Anwendung von Anodenkurzschlüssen ist allgemein vorteilhaft.

Eine kleinere elektrische Leitfähigkeit von Anodenkurzschlüssen kann beispielsweise durch einen größeren Abstand der Anodenkurzschlüsse voneinander und/oder einen geringeren Durchmesser dieser Kurzschlüsse erreicht werden.

Demgemäß weisen bei einer vorteilhaften und bevorzugten Ausführungsform des erfindungsgemäßen Thyristors Anodenkurzschlüsse unterhalb der Metallisierung der wenigstens einen Treiberstufe einen größeren Abstand voneinander und/oder einen geringeren Durchmesser als unterhalb der Kathode des Thyristors auf.

Zusätzlich ist es vorteilhaft, die Ladungsträger-Lebensdauer in einem außerhalb der Kathode des Thyristors liegenden Bereich des Körpers aus Halbleitermaterial größer, vorzugsweise deutlich höher als in dem unterhalb der Kathode liegenden Bereich einzustellen. Dies läßt sich zum Beispiel durch eine maskierte Bestrahlung des Körpers mit Elektronen oder Protonen realisieren, wobei der außerhalb der Kathode liegende Bereich während der Bestrahlung mit einer Metallmaske abgedeckt wird und der unterhalb der Kathode liegende Bereich offen ist. Um eine sinnvolle Abstufung der Trägerlebensdauer im außerhalb der Kathode liegenden Bereich und der Trägerlebensdauer im unterhalb der Kathode liegenden Bereich mit dem Ziel zufriedenstellender Kippspannungen und Freiwerdezeiten zu erreichen, sollte im Allgemeinen eine zweite ganzflächige Bestrahlung des Körpers zeitlich vor- und/oder nachgeschaltet sein.

Eine vorteilhafte Weiterbildung der Erfindung ist eine Anordnung aus einem erfindungsgemäßen asymmetrischen Thyristor und einer Diode, wobei der Thyristor und die Diode elektrisch miteinander verbunden sind. Durch diese Anordnung ist ein neuartiger Tandemthyristor geschaffen, der den Vorteil aufweist, daß der asymmetrische Thyristor bei Sperrbelastung in Rückwärtsrichtung keine Raumladungszone aufweist, so daß in diesem Fall ein raumladungsbedingtes Ausräumen freier Ladungsträger, insbesondere der freien Ladungsträger, mit denen die Treiberstufe überschwemmt ist, entfällt, und somit diese freien Ladungsträger länger erhalten bleiben.

Durch die Erfindung ist vorteilhafterweise ein integrierter Freiwerdeschutz realisierbar, der unter allen Betriebsbedingungen wirksam ist.

Die Erfindung wird in der nachfolgenden Beschreibung anhand der Zeichnung beispielhaft näher erläutert.

Die Figur zeigt ein Ausführungsbeispiel des erfindungsgemäßen Thyristors im Querschnitt.

Der in der Figur im Querschnitt dargestellte und generell mit 1 bezeichnete Thyristor weist einen Körper 10 aus unterschiedlich dotiertem Halbleitermaterial, beispielsweise Silizium, auf. Der Körper 10 hat beispielsweise die Form einer Scheibe, die zwei voneinander abgekehrte Hauptflächen 11 und 12 aufweist.

Auf der Hauptfläche 11 ist eine als Kathode des Thyristors 1 dienende Elektrode 13 und auf der Hauptfläche 12 eine als Anode des Thyristors 1 dienende Elektrode 14 ausgebildet.

Der Thyristor 1 ist beispielsweise rotationssymmetrisch bezüglich einer auf den beiden Hauptflächen 11 und 12 des Körpers 10 senkrecht stehenden Achse A.

Der kathodenseitige Emitter des ersten Leitungstyps ist durch einen an die Hauptfläche 11 des Körpers 10 grenzenden n⁺dotierten Bereich 15 dieses Körpers 10 definiert.

Die kathodenseitige Basis des zweiten Leitungstyps ist durch einen an den n⁺-dotierten Bereich 15 grenzenden und zusammen mit diesem Bereich 15 einen np-Übergang 156 bildenden p-dotierten Bereich 16 des Körpers 10 definiert.

Die anodenseitige Basis 17 des ersten Leitungstyps ist durch einen n⁻-dotierten Bereich 171 und einen n⁺-dotierten Bereich 172 des Körpers 10 definiert, die aneinandergrenzen und von denen der n⁻-dotierten Bereich 171 an den p-dotierten Bereich 16 der kathodenseitigen Basis grenzt und zusammen mit diesem Bereich 16 einen pn-Übergang 167 bildet.

Der anodenseitige Emitter des zweiten Leitungstyps ist durch einen p⁺-dotierten Bereich 18 des Körpers 10 definiert, der einerseits an den n⁺-dotierten Bereich 172 der anodenseitigen Basis 17 grenzt und zusammen mit diesem Bereich 172 einen np-Übergang 178 bildet und andererseits an die Hauptfläche 12 des Körpers 10 grenzt.

Im kathodenseitigen Emitter 15 sind ein oder mehrere Kathodenkurzschlüsse 160 ausgebildet, deren jeder die kathodenseitigen Basis 16 und die Kathode 13 miteinander verbindet. Diese Kathodenkurzschlüsse 160 gewährleisten, daß der Thyristor 1 auch bei einer großen dU/dt-Belastung von einigen 1000 Volt/µs nicht bereits vor dem Erreichen der statischen Kippspannung unkontrolliert zündet.

Um den Einfluß eines Leckstromes auf den durch die kathodenseitige Basis 16, die anodenseitigen Basis 17 und den anodenseitigen Emitter 18 definierten Transistorverstärkungsfaktor αₚₙₚ des Thyristors 1 bei geringen Leckstromdichten zu unterdrücken, sind im anodenseitigen Emitter 18 ein oder mehrere Anodenkurzschlüsse 174 ausgebildet, deren jeder die anodenseitige Basis 17 und die Anode 14 miteinander verbindet.

Der Körper 10 weist wenigstens eine Treiberstufe 20 zum Verstärken eines in die kathodenseitige Basis 16 durch die Hauptfläche 11 eingespeisten Steuerstromes I auf.

Die Treiberstufe 20 weist einen im p-dotierten Bereich 16 der kathodenseitigen Basis ausgebildeten und vom kathodenseitigen Emitter 15 und der Kathode 13 Basis des Thyristors 1 räumlich getrennten weiteren Emitter 21 in Form eines an die Hauptfläche 11 des Körpers 10 grenzenden und beispielsweise n⁺dotierten Bereichs sowie eine auf dieser Hauptfläche 11 des Körpers 10 ausgebildete und vom kathodenseitigen Emitter 15 und der Kathode 13 Basis des Thyristors 1 räumlich getrennte Metallisierung 22 auf, die sowohl den n⁺-dotierten weiteren Emitter 21 als auch die seitlich neben dem weiteren Emitter 21 ebenfalls an die Hauptfläche 11 des Körpers 10 grenzende p-dotierte kathodenseitige Basis 16 kontaktiert.

Der n⁺-dotierte weitere Emitter 21 der Treiberstufe bildet zusammen mit der p-dotierten kathodenseitigen Basis 16 des Thyristors einen np-Übergang 162.

Anstelle nur einer Treiberstufe 21 können eine oder mehrere nicht dargestellte zusätzliche Treiberstufen vorhanden sein, deren jede je einen an die Hauptfläche 11 des Körpers 10 grenzenden weiteren Emitter und je eine auf dieser Hauptfläche 11 ausgebildete Metallisierung aufweist, die sowohl diesen weiteren Emitter als auch die kathodenseitige Basis 16 kontaktiert. Der weitere Emitter und die Metallisierung jeder zusätzlichen Treiberstufe sind räumlich vom Emitter und der Metallisierung der Treiberstufe 20 und jeder anderen zusätzlichen Treiberstufe sowie vom kathodenseitigen Emitter 15 und der Kathode 13 des Thyristors 1 getrennt angeordnet.

Der in die kathodenseitigen Basis 16 eingespeiste Steuerstrom I wird an einer Stelle 30 der Hauptfläche 11 des Körpers 10 erzeugt, die sich neben dem n⁺-dotierten weiteren Emitter 21 der Treiberstufe 20 befindet und an der die kathodenseitige Basis 16 frei von der Metallisierung 22 der Treiberstufe 20 und der Kathode 13 des Thyristors 1 an die Hauptfläche 11 des Körpers 10 grenzt.

Die Stelle 30 zum Einspeisen des Steuerstroms I ist beispielsweise ein die Achse A umgebender zentraler Teilbereich der Hauptfläche 11 des Körpers 10.

Der Steuerstrom I kann mit Hilfe einer auf oder unter der Stelle 30 ausgebildeten nicht dargestellten lichtempfindlichen Struktur durch Einstrahlen optischer Strahlung 31 in die Struktur und/oder eines auf dieser Stelle 30 ausgebildeten und ebenfalls nicht dargestellten Zündkontes (siehe dazu beispielsweise WO 98/34282) erzeugt werden.

Die Treiberstufe 20 ist radial zur Achse A zwischen der Stelle 30 und dem kathodenseitigen Emitter 15 und der Kathode 13 des Thyristors 1 angeordnet.

Der Thyristor 1 und die Treiberstufe 20 sind erfindungsgemäß so ausgebildet und bemessen, daß
- der unterhalb der Metallisierung 22 der Treiberstufe 20 durch den weiteren Emitter 21, die kathodenseitige Basis 16 und die anodenseitige Basis 17 definierte Transistorverstärkungsfaktor α'ₙₚₙ dieser Treiberstufe 20 größer ist als der unterhalb der Kathode 13 des Thyristors 1 durch den kathodenseitigen Emitter 15, die kathodenseitige Basis 16 und die anodenseitige Basis 17 definierte Transistorverstärkungsfaktor αₙₚₙ des Thyristors 1, und/oder daß
- der unterhalb der Metallisierung 22 der wenigstens einen Treiberstufe 20 durch die kathodenseitige Basis 16, die anodenseitige Basis 17 und den anodenseitigen Emitter 18 definierte Transistorverstärkungsfaktor α'ₚₙₚ dieser Treiberstufe 20 größer ist als der unterhalb der Kathode 13 des Thyristors 1 durch die kathodenseitige Basis 16, die anodenseitige Basis 17 und den anodenseitigen Emitter 18 definierte Transistorverstärkungsfaktor αₚₙₚ des Thyristors 1.

Vorzugsweise ist α'ₙₚₙ > αₙₚₙ und zugleich α'ₚₙₚ > αₚₙₚ gewählt.

Sind neben der Treiberstufe 20 eine oder mehrere zusätzliche Treiberstufen vorhanden, so kann die vorstehende Vorschrift auch für eine oder mehrere oder sogar jede zusätzliche Treiberstufe realisiert sein, obgleich es genügt, wenn diese Vorschrift nur für eine einzige der mehreren Treiberstufen, im vorliegenden Fall für die Treiberstufe 20 realisiert ist.

Der beispielhafte Thyristor 1 ist ein asymmetrischer Thyristor, bei dem die anodenseitige Basis 17 eine Stoppzone des ersten Leitungstyps n aufweist, die durch den n⁺-dotierten Bereich 172 dieser Basis 17 gebildet ist.

Bei einem solchen asymmetrischen Thyristor 1 kann die vorstehende Dimensionsvorschrift bezüglich der Transistorverstärkungsfaktoren auf einfache Weise dadurch realisiert werden, daß die Stoppzone 172 in einem unterhalb der Metallisierung 22 der wenigstens einen Treiberstufe 20 liegenden Bereich 220 schwächer dotiert ist als in einem unterhalb der Kathode 13 des Thyristors 1 liegenden Bereich 130.

Der schwächer dotierte Bereich 220 der Stoppzone 172 erstreckt sich vorzugsweise bis unter die Stelle 30 zum Einspeisen eines Steuerstromes I in die kathodenseitige Basis 16.

Der sich auch unter der Stelle 30 erstreckende schwächer dotierte Bereich 220 der Stoppzone 172 kann unter dieser Stelle 30 gleich schwach dotiert sein wie außerhalb dieser stelle 30.

Die Stoppzone 172 kann in dem unterhalb der Metallisierung 22 der wenigstens einen Treiberstufe 20 liegenden Bereich 220 auch höher dotiert sein als in dem unterhalb der Stelle 30 liegenden Bereich 300, der durch die zur Achse A parallele gestrichelte Linie 301 vom übrigen schwächer dotierten Bereich 220 der Stoppzone 172 abgegrenzt ist.

Die Anodenkurzschlüsse 174 weisen unterhalb der Metallisierung 22 der Treiberstufe 20 eine kleinere elektrische Leitfähigkeit als unterhalb der Kathode 13 des Thyristors 1 auf. Dies ist auf einfache Weise dadurch realisiert, daß ein Abstand d1 der Anodenkurzschlüsse 174 voneinander unterhalb der Metallisierung 22 der Treiberstufe 20 größer als unterhalb der Kathode 13 des Thyristors 1 ist und/oder ein Durchmesser d2 der Anodenkurzschlüsse 174 unterhalb der Metallisierung 22 der Treiberstufe 20 kleiner als unterhalb der Kathode 13 des Thyristors 1 ist.

Bei Vorhandensein eines oder mehrerer zusätzlicher Treiberstufen kann diese Maßnahme alternativ zur Treiberstufe 20 oder zusätzlich zu dieser bei einer, mehreren oder allen zusätzlichen Treiberstufen realisiert sein.

Wird an die Anode 14 des Thyristors 1 wie in der Figur dargestellt eine Diode 4 angeschlossen, so ist ein asymmetrischer Tandemthyristor realisiert.

## Patentansprüche

1. Thyristor (1) mit dem folgenden Aufbau:
In einem Körper (10) aus unterschiedlich dotiertem Halbleitermaterial, der eine als Kathode dienende Elektrode (13) sowie eine als Anode dienende Elektrode (14) aufweist, sind
- ein kathodenseitiger Emitter (15) eines ersten Leitungstyps (n)
- eine kathodenseitige Basis (16) eines zweiten Leitungstyps (p),
- eine anodenseitige Basis (17) des ersten Leitungstyps (n),
- ein anodenseitiger Emitter (18) des zweiten Leitungstyps (p) und
- wenigstens eine Treiberstufe (20) zum Verstärken eines in die kathodenseitige Basis (16) eingespeisten Steuerstromes (I) ausgebildet und
- die Treiberstufe (20) weist einen in der kathodenseitigen Basis (16) ausgebildeten und vom kathodenseitigen Emitter (15) getrennten weiteren Emitter (21) des ersten Leitungstyps (n) sowie eine sowohl die kathodenseitige Basis (16) als auch den weiteren Emitter (21) kontaktierende Metallisierung (22) auf, **dadurch gekennzeichnet, dass**
- ein unterhalb der Metallisierung (22) der wenigstens einen Treiberstufe (20) durch den weiteren Emitter (21), die kathodenseitige Basis (16) und die anodenseitige Basis (17) definierter Transistorverstärkungsfaktor (α'ₙₚₙ) dieser Treiberstufe (20) größer ist als ein unterhalb der Kathode (13) des Thyristors (1) durch den kathodenseitigen Emitter (15), die kathodenseitige Basis (16) und die anodenseitige Basis (17) definierter Transistorverstärkungsfaktor (αₙₚₙ) des Thyristors (1),
und/oder
- ein unterhalb der Metallisierung (22) der wenigstens einen Treiberstufe (20) durch die kathodenseitige Basis (16), die anodenseitige Basis (17) und den anodenseitigen Emitter (18) definierter Transistorverstärkungsfaktor (α'ₚₙₚ) dieser Treiberstufe (20) größer ist als ein unterhalb der Kathode (13) des Thyristors (1) durch die kathodenseitige Basis (16), die anodenseitige Basis (17) und den anodenseitigen Emitter (18) definierter Transistorverstärkungsfaktor (αₚₙₚ) des Thyristors (1) und/oder
- Anodenkurzschlüsse (174) die anodenseitige Basis (17) und die Anode (14) miteinander verbinden und unterhalb der Metallisierung (22) der wenigstens einen Treiberstufe (20) eine kleinere elektrische Leitfähigkeit als unterhalb der Kathode (13) des Thyristors (1) aufweisen.

2. Thyristor nach Anspruch 1, **dadurch gekennzeichnet, daß** die anodenseitige Basis (17) eine Stoppzone (172) des ersten Leitungstyps (n) aufweist.

3. Thyristor nach Anspruch 2, **dadurch gekennzeichnet, daß** die Stoppzone (172) in einem unterhalb der Metallisierung (22) der wenigstens einen Treiberstufe (20) liegenden Bereich (220) schwächer dotiert ist als in einem unterhalb der Kathode (13) des Thyristors (1) liegenden Bereich (130).

4. Thyristor nach Anspruch 2 oder 3, **dadurch gekennzeichnet, daß** die Stoppzone (172) in dem unterhalb der Metallisierung (22) der wenigstens einen Treiberstufe (20) liegenden Bereich (220) höher dotiert ist als in einem unterhalb einer Stelle (30) zum Einspeisen eines Steuerstroms (I) in die kathodenseitige Basis (16) liegenden Bereich (300).

5. Thyristor nach einem der vorhergehenden Ansprüche, **dadurch gekennzeichnet, daß** die Anodenkurzschlüsse (174) unterhalb der Metallisierung (22) der Treiberstufe (20) einen größeren Abstand (d1) voneinander und/oder einen geringeren Durchmesser (d2) als unterhalb der Kathode (13) des Thyristors (1) aufweisen

6. Anordnung aus einem Thyristor (1) nach einem der Ansprüche 2 bis 4 und einer Diode (4), wobei der Thyristor (1) und die Diode (4) elektrisch miteinander verbunden sind.

## Claims

1. Thyristor (1) having the following construction:
in a body (10) made of differently doped semiconductor material which has an electrode (13) serving as cathode and also an electrode (14) serving as anode, there are formed
- a cathodal emitter (15) of a first conduction type (n)
- a cathodal base (16) of a second conduction type (P),
- an anodal base (17) of the first conduction type (n),
- an anodal emitter (18) of the second conduction type (p) and
- at least one driver stage (20) for amplifying a control current (I) fed into the cathodal base (16) and
- the driver stage (20) has a further emitter (21) of the first conduction type (n), which is formed in the cathodal base (16) and is isolated from the cathodal emitter (15), and also a metallization layer (22) which makes contact both with the cathodal base (16) and with the further emitter (21), **characterized in that**
- a transistor gain factor (α'ₙₚₙ) of the at least one driver stage (20), which factor is defined, below the metallization layer (22) of the said driver stage (20), by the further emitter (21), the cathodal base (16) and the anodal base (17), is greater than a transistor gain factor (αₙₚₙ) of the thyristor (1), which factor is defined, below the cathode (13) of the thyristor (1) by the cathodal emitter (15), the cathodal base (16) and the anodal base (17),
and/or
- a transistor gain factor (α'ₚₙₚ) of the at least one driver stage (20), which factor is defined, below the metallization layer (22) of the said driver stage (20), by the cathodal base (16), the anodal base (17) and the anodal emitter (18), is greater than a transistor gain factor (αₚₙₚ) of the thyristor (1), which factor is defined, below the cathode (13) of the thyristor (1), by the cathodal base (16), the anodal base (17) and the anodal emitter (18), and/or
- anode short circuits (174) connect the anodal base (17) and the anode (14) to one another and have a smaller electrical conductivity below the metallization layer (22) of the at least one driver stage (20) than below the cathode (13) of the thyristor (1).

2. Thyristor according to Claim 1, **characterized in that** the anodal base (17) has a stop zone (172) of the first conduction type (n).

3. Thyristor according to Claim 2, **characterized in that** the stop zone (172) is doped more weakly in a region (220) lying below the metallization layer (22) of the at least one driver stage (20) than in a region (130) lying below the cathode (13) of the thyristor (1).

4. Thyristor according to Claim 2 or 3, **characterized in that** the stop zone (172) is doped more highly in the region (220) lying below the metallization layer (22) of the at least one driver stage (20) than in a region (300) lying below a location (30) for feeding a control current (I) into the cathodal base (16).

5. Thyristor according to one of the preceding claims, **characterized in that** the anode short circuits (174), below the metallization layer (22) of the driver stage (20), are at a greater distance (d1) from one another and/or have a smaller diameter (d2) than below the cathode (13) of the thyristor (1).

6. Arrangement comprising a thyristor (1) according to one of Claims 2 to 4 and a diode (4), the thyristor (1) and the diode (4) being electrically connected to one another.

## Revendications

1. Thyristor (1) avec la structure suivante :
- un émetteur cathodique (15) d'un premier type de ligne (n),
- une base cathodique (16) d'un second type de ligne (p),
- une base anodique (17) du premier type de ligne (n),
- un émetteur anodique (18) du second type de ligne (p) et
- au moins un étage d'attaque (20) pour l'amplification d'un courant de pilotage (I) alimenté dans la base cathodique (16),
sont formés dans un corps (10) constitué d'un matériau semi-conducteur dopé à des degrés divers, qui comporte une électrode (13) servant de cathode ainsi qu'une électrode (14) servant d'anode et,
- l'étage d'attaque (20) présente un autre émetteur (21) du premier type de ligne (n) formé dans la base cathodique (16) et séparé de l'émetteur cathodique (15), ainsi qu'une métallisation (22) au contact tant de la base cathodique (16) que de l'autre émetteur (21), **caractérisé en ce que**
- un facteur d'amplification de transistor (α'ₙₚₙ) de cet étage d'attaque (20) se trouvant sous la métallisation (22) de l'au moins un étage d'attaque (20) étant défini par l'autre émetteur (21), la base cathodique (16) et la base anodique (17), est plus grand qu'un facteur d'amplification de transistor (αₙₚₙ) du thyristor (1) se trouvant en dessous de la cathode (13) du thyristor (1) et étant défini par l'émetteur cathodique (15), la base cathodique (16) et la base anodique (17), et/ou
- un facteur d'amplification de transistor (α'ₚₙₚ) de cet étage d'attaque (20) se trouvant sous la métallisation (22) de l'au moins un étage d'attaque (20) et étant défini par la base cathodique (16), la base anodique (17) et l'émetteur anodique (18), est plus grand qu'un facteur d'amplification de transistor (αₚₙₚ) du thyristor (1) se trouvant sous la cathode (13) du thyristor (1) et étant défini par la base cathodique (16), la base anodique (17) et l'émetteur anodique (18) et/ou
- des courts-circuits anodiques (174) relient la base anodique (17) et l'anode (14) l'une avec l'autre et présentent sous la métallisation (22) de l'au moins un étage d'attaque (20) une conductibilité électrique moindre que sous la cathode (13) du thyristor (1).

2. Thyristor selon la revendication 1, **caractérisé en ce que** la base anodique (17) comporte une zone d'arrêt (172) du premier type de ligne (n).

3. Thyristor selon la revendication 2, **caractérisé en ce que** la zone d'arrêt (172) dans une zone (220) située en dessous de la métallisation (22) de l'au moins un étage d'attaque (20) est plus faiblement dopée que dans une zone (130) se trouvant sous la cathode (13) du thyristor (1).

4. Thyristor selon la revendication 2 ou 3, **caractérisé en ce que** la zone d'arrêt (172) dans la zone (220) située en dessous de la métallisation (22) de l'au moins un étage d'attaque (20) est plus fortement dopée que dans une zone (300) se trouvant sous un point (30) d'alimentation d'un courant de pilotage (I) dans la base cathodique (16).

5. Thyristor selon l'une des revendications précédentes, **caractérisé en ce que** les courts-circuits anodiques (174) présentent sous la métallisation (22) de l'étage d'attaque (20) un espacement (d1) les uns des autres plus grand et/ou un diamètre (d2) plus petit que sous la cathode (13) du thyristor (1).

6. Dispositif constitué d'un thyristor (1) selon l'une des revendications 2 à 4 et d'une diode (4), le thyristor (1) et la diode (4) étant reliés électriquement l'un à l'autre.
